Europäisches Patentamt

European Patent Office

Office européen des brevets

(19)

(11) Numéro de publication: **0 099 290**
**B1**

# (12) FASCICULE DE BREVET EUROPEEN

(45) Date de publication du fascicule du brevet:
**11.03.87**

(21) Numéro de dépôt: **83401392.2**

(22) Date de dépôt: **06.07.83**

(51) Int. Cl.⁴: **G 01 R 15/08, H 01 H 36/00**

(54) Commutateur automatique à haut isolement et faibles consommation et encombrement.

(30) Priorité: **09.07.82 FR 8212115**

(43) Date de publication de la demande:
**25.01.84 Bulletin 84/4**

(45) Mention de la délivrance du brevet:
**11.03.87 Bulletin 87/11**

(84) Etats contractants désignés:
**CH DE GB IT LI**

(56) Documents cités:
**DE - A - 1 563 748
DE - A - 1 923 473
FR - A - 2 001 667
FR - A - 2 096 102
US - A - 3 660 789**

**ELECTRONIQUE ET APPLICATION INDUSTRIELLE, no. 255, juin 1978, page 16, Paris, FR. J. BRIAUD: "Changement de gamme automatique"**

(73) Titulaire: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Bonnet, Bernard, 152, Rue Lamarck, F-75018 Paris (FR)**
Inventeur: **Bressy, Roger, 37, rue Bernard Iské, F-92350 Le Plessis Robinson (FR)**
Inventeur: **Sevaille, Jean-Claude, 6, Allée de la Dordogne, F-77176 Savigny le Temple (FR)**

(74) Mandataire: **Mongrédien, André et al, c/o BREVATOME 25, rue de Ponthieu, F-75008 Paris (FR)**

## Description

La présente invention concerne un commutateur automatique à haut isolement et faibles consommation et encombrement. Elle concerne le domaine de la mesure électrique de courants d'intensités très faibles dont les valeurs s'échelonnent sur plusieurs décades et, plus particulièrement, concerne le cas où cette mesure est effectuée, de manière connue, à l'aide d'un appareil électrométrique constitué d'un amplificateur intégré précédé d'au moins un transistor à effet de champ à porte isolée de très faible courant de fuite, l'ensemble transistor-amplificateur étant contre-réactionné linéairement par des résistances de hautes valeurs que l'un commute selon la gamme de mesures à mettre en œuvre.

Par exemple, ce cas est celui de la mesure des courants très faibles, d'intensités comprises entre $10^{-14}$ et $10^{-7}$ ampère, issus d'une chambre d'ionisation. Les valeurs des résistances de contre-réaction sont alors comprises entre $10^6$ et $10^{12}$ ohms selon la gamme de mesure.

L'invention est plus précisément relative au dispositif de commutation utilisé pour commuter ces résistances de hautes valeurs, et qui doit posséder des caractéristiques d'isolement compatibles avec ces valeurs élevées de résistances.

Plus précisément encore, l'invention est relative aux dispositifs antérieurement connus de commutation qui utilisent des interrupteurs à lame souple à commande magnétique enfermés dans des ampoules, connus sous les références commerciales d'ampoules Reed ou d'interrupteurs ILS, montés en série avec les différentes résistances de hautes valeurs utilisées pour les différentes gammes de mesure, et qui se ferment lorsqu'ils sont soumis à l'action d'un champ magnétique.

Jusqu'alors, dans les dispositifs de commutation connus d'un premier type, ce champ magnétique est engendré par des relais qui présentent l'inconvénient d'avoir une consommation assez élevée à cause de leur circuit magnétique qui doit être imparfaitement fermé afin de respecter les lignes de fuite de l'ampoule-interrupteur nécessaires à l'isolement.

Dans les dispositifs de commutation connus d'un second type, ce champ magnétique est engendré par un aimant permanent qu'un dispositif de commande manuelle vient positionner devant celle des ampoules-interrupteurs dont on désire fermer le contact. On évite ainsi l'inconvénient précité d'une consommation permanente de courant élevée, mais au prix de l'inconvénient d'utiliser une commande manuelle.

L'invention a pour but de supprimer ces deux inconvénients, ce qui est particulièrement nécessaire lorsque l'on désire disposer d'un appareil de mesure de courants très faibles portatif et automatique. Dans ce cas-là, il faut alors nécessairement et conjointement que l'appareil soit alimenté par piles donc à consommation minimale, que les gammes de mesures soient commutées automatiquement, et que l'ensemble soit d'un poids et d'un encombrement restreints.

A ces effets, l'invention a donc pour objet un commutateur automatique à haut isolement et faibles consommation et encombrement, destiné à être associé à un appareil électrométrique constitué d'un amplificateur intégré précédé d'au moins un transistor, l'ensemble transistor-amplificateur étant contre-réactionné linéairement par des résistances de hautes valeurs commutées selon la gamme de mesures à mettre en œuvre par des interrupteurs, ledit commutateur comprenant des moyens de commande des interrupteurs et des moyens de comparaison de tension, caractérisé en ce que le transistor est un transistor à effet de champ à porte isolée de très faible courant de fuite, en ce que les interrupteurs sont des interrupteurs à lame souple à commande magnétique engendrée par un aimant permanent et en ce que les moyens de commande des interrupteurs comprennent un servo-mécanisme à moteur et potentiomètre pour positionner ledit aimant permanent en regard de l'un desdits interrupteurs à lame souple à commande magnétique, les moyens de comparaison étant prévus pour comparer la tension de sortie dudit amplificateur et la tension délivrée par ledit potentiomètre à des valeurs de consigne et caractéristique de la position dudit aimant permanent et, en outre, commander en conséquence ledit moteur de déplacement de l'aimant.

L'automaticité du commutateur selon l'invention est assurée par l'utilisation en combinaison avec lui du servo-mécanisme et de ses moyens de commande, qui peuvent être réalisés très simplement à l'aide de moyens connus, tels que dispositif convertisseur analogique-digital, et dispositif microprocesseur, comme on le décrira ci-après plus en détail.

Le haut isolement du commutateur résulte de l'emploi, en série avec les résistances de hautes valeurs correspondant aux différentes gammes de mesure, d'interrupteurs à lame souple à commande magnétique à très haut isolement, par exemple supérieur à $10^{14}$ ohms.

La faible consommation du commutateur résulte de ce que le moteur du servo-mécanisme ne consomme de courant qu'au moment d'une commutation, son courant de repos en position stable étant nul.

La combinaison de moyens de l'invention permet un positionnement très précis de l'aimant permanent en chacune de ses positions stables, ce qui permet une optimalisation des dimensions des divers éléments composants du commutateur et, par conséquent, la réduction optimale de son encombrement, nécessaire à la réalisation d'un appareil portatif.

Certes, on connaît par l'article de J. BRIAUD, publié dans «Electronqiue et Application Industrielle», n° 255, juin 1978, un dispositif de changement de gamme automatique pour mesure analogique comme dans le préambule de la revendication 1. Mais ce dispositif ne comprend notamment pas le servo-mécanisme de l'invention. On connaît également le brevet FR-A-2 096 102 qui divulgue simplement un commutateur à lames magnétiques commandé par un aimant permanent.

L'invention a pour autre but de protéger avec toute garantie le transistor à effet de champ à l'entrée de l'amplificateur lorsque l'appareil est hors tension. En effet, la porte isolée de ce transistor est extrêmement sensible aux surcharges électriques ou électrostatiques dues aux variations transitoires de tension se produisant à la mise sous tension de l'appareil de mesure, tant que le régime n'est pas complètement établi.

A cet effet, l'invention a pour autre object un commutateur du type précité, caractérisé en ce qu'un autre interrupteur à lame souple à commande magnétique en regard duquel vient se placer ledit aimant permanent après arrêt de l'appareil assure la mise en court-circuit dudit ensemble transistor-amplificateur lorsque l'appareil est hors tension.

Selon un mode de réalisation particulier de l'invention, ledit autre interrupteur à lame souple à commande magnétique est associé à un autre interrupteur à lame souple à commande magnétique de coupure d'alimentation de l'appareil de mesure en position arrêt.

La présente invention a encore pour autre but de réaliser matériellement un sous-composant de l'appareil de mesure proprement dit comprenant: les ampoules-interrupteurs, leurs résistances de hautes valeurs montées en série avec elles, le moteur et le potentiomètre du servo-mécanisme, qui soit simple, compact et miniaturisé.

A ces effets, l'invention a pour autre objet un commutateur du type précité, caractérisé en ce qu'il comporte: un corps profilé en U ayant une base et deux ailes parallèles en regard; un moteur de servo-mécanique monté à l'extérieur du corps sur l'une des ailes, son axe passant par un orifice de cette aile; un potentiomètre de servo-mécanisme monté à l'extérieur du corps sur l'autre aile, son axe étant coaxiale avec le premier axe et passant par un orifice de cette autre aile; un accouplement élastique connectant mécaniquement les deux axes précités du moteur et du potentiomètre; un aimant permanent de forme rectiligne, parallèle aux axes précités, excentré par rapport à eux et entraîné en rotation par l'axe du moteur; plusieurs ampoules-interrupteurs à lame souple à commande magnétique montées entre les deux ailes du corps profilé parallèlement à l'axe du moteur à même distance de cet axe et régulièrement espacées les unes des autres de telle sorte que ledit aimant permanent lors de sa rotation vient se placer successivement en regard et à proximité de ces ampoules-interrupteurs pour les commander; et plusieurs résistances de hautes valeurs montées sur l'une et/ou l'autre des ailes du corps profilé.

Un avantage supplémentaire de l'invention résulte de ce mode de réalisation et consiste en ce que l'on peut ainsi obtenir une excellente stabilité de chaque position de l'aimant permanent en l'une ou l'autre de ses différentes positions possibles. Cette stabilité n'est pas affectée par des chocs et/ou vibrations.

Pour mieux faire comprendre tous les buts, objets et avantages exposés ci-dessus de l'invention, on en décrira maintenant un exemple non limitatif de réalisation.

On le fera en se reportant du dessin annexé, sur lequel:

— la figure 1 est le schéma électrique et électronique du commutateur et de ses moyens fonctionnels de commande, et

— la figure 2 est une vue en perspective d'une réalisation matérielle avantageuse du commutateur de la figure 1.

Le courant très faible è mesurer, d'intensité I, provenant par exemple d'une chambre d'ionisation, est appliqué à la porte d'un transistor MOS Fet à effet de champ TR1 précédant un amplificateur intégré AI.

Par exemple, I variera sur 7 décades avec des intensités de $10^{-14}$ à $10^{-7}$ ampère.

Cet ensemble transistor TR1-amplificateur AI est contre-réactionné linéairement par des résistances de hautes valeurs R4, R3, R2, R1 de valeurs respectives $10^6$, $10^8$, $10^{10}$ et $10^{12}$ ohms suivant la gamme de mesure.

Les résistances R2, R3 et R4 sont montées en série avec des éléments de commutation constitués d'interrupteurs à lame souple à commande magnétique IM2, IM3 et IM4, tels que des ampoules Reed.

Ces interrupteurs sont fermés par un aimant permanent tournant AP qui est entraîné en rotation par un moteur M d'un servo-mécanisme, actionnant également le déplacement du curseur d'un potentiomètre P.

On a schématisé par un cercle en traits interrompus le mouvement circulaire de l'aimant AP et repéré en p1, p2, p3, p4 et p5 les cinq positions stables qu'il est susceptible d'occuper.

En position p1, la résistance R1 est en contre-réaction de l'amplificateur AI. En position p2, les résistances R1 et R2 en parallèle sont en service. En position p3, les résistances R1 et R3 en parallèle sont en service. En position P4, les résistancers R1 et R4 en parallèle sont en service.

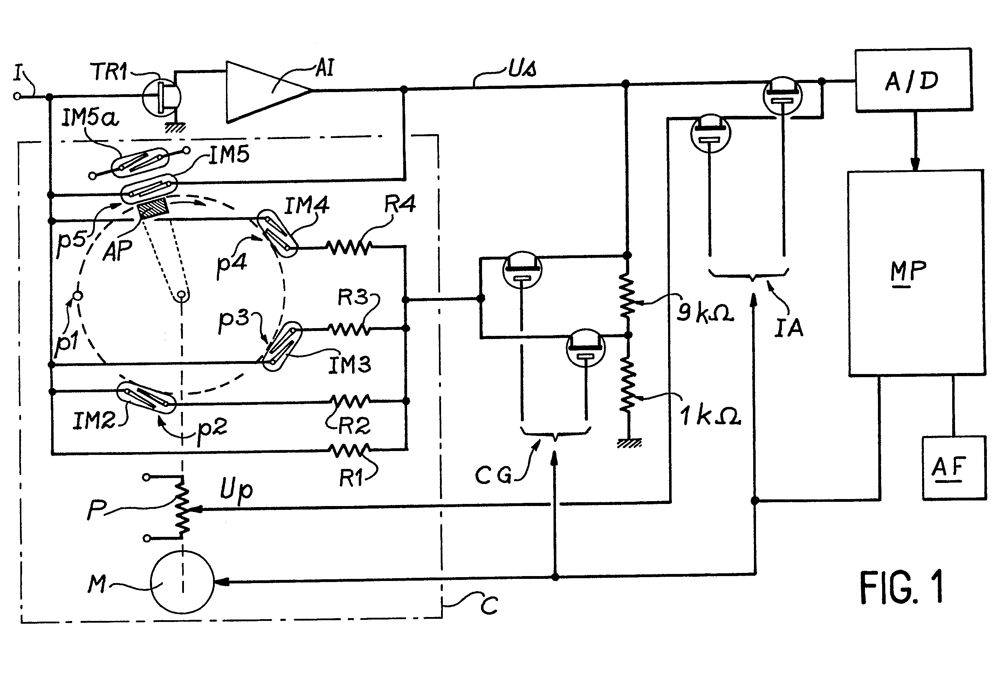

En position p5, qui correspond à la position de l'aimant AP représentée sur la figure 1, un interrupteur IM5 se ferme, mettant en court-circuit l'ensemble transistor TR1-amplificateur AI. Cet interrupteur est doublé d'un autre interrupteur IM5a, qui s'ouvre sous l'action de l'aimant AP et coupe l'alimentation générale de l'appareil électrométrique comme on l'expliquera ci-après.

L'ensemble des éléments comprenant le moteur M, le potentiomètre P, l'aimant premanent AP, les résistances de hautes valeurs R1, R2, R3 et R4 et les interrupteurs à commande magnétique IM2, IM3, IM4, IM5 et IM5a, et représenté à l'intérieur du cadre en traits mixtes C, constitue la combinaison de moyens caractéristique du commutateur selon l'invention.

Cette combinaison de moyens est pilotée par un microprocesseur MP dont la fonction essentielle consiste à prendre en compte la tension de sortie Us de l'amplificateur Al et la tension Up prélevée sur le curseur du potentiomètre P, à les comparer à des valeurs de références stockées en mémoire, et à contrôler en conséquence le moteur M de commande du commutateur. Le microprocesseur MP contrôle également l'affichage de la gamme de mesure utilisée et de la mesure faite dans un dispositif d'affichage AF de tout type connu.

Afin de limiter le nombrte des résistances de hautes valeurs à commuter, on utilise une commutation de gain de l'amplificateur Al de 1 et de 10, commutation à basse impédance réalisée par un commutateur en semi-conducteur intégré de type connu schématisé en CG.

Les tensions Us et Up sont successivement testées, à l'aide d'un interrupteur analogique IA de type connu, et digitalisées par un convertisseur A/D analogue/digital, également de type connu.

Le fonctionnement de l'ensemble commutateur-appareil électrométrique décrit ci-dessus est le suivant.

Lorsque l'appareil est en position «arrêt», le commutateur C est en position p5, c'est-à-dire que l'amplificateur Al est en court-circuit et que l'alimentation électrique est coupée par l'interrupteur IM5a alors ouvert par l'aimant AP qui est en regard de lui. On expliquera ci-après comment l'on obtient cette situation initiale.

Lorsque l'appareil est mis en position «marche» par le commutateur Marche-Arrêt manuel, le microprocesseur MP donne l'ordre au moteur M de tourner. L'interrupteur IM5a se ferme, se mettant alors en parallèle avec le commutateur Marche-Arrêt manuel.

L'aimant AP se met en marche vers la position p4 pour mesurer éventuellement le courant I le plus fort ($10^{-7}$ ampère) avec la résistance la plus faible (R4, valeur $10^6$ ohms, en parallèle avec R1, valeur $10^{12}$ ohms).

Le microprocesseur MP compare la tension Up sur le curseur du potentiomètre P à la valeur de consigne contenue en mémoire et correspondant à la position p4. Lorsque ces valeurs sont égales, le moteur M est arrêté en position p4 et le microprocesseur MP se commute, par l'action de l'interrupteur analogique IA, sur la tension de sortie Us de l'amplificateur Al.

Cette tension de sortie Us est d'abord testée en gain de 10.

Si la valeur de la tension Us est comprise entre 10% et 100% de la première gamme de mesures à laquelle correspond l'amplificateur Al contre-réactionné par les résistances R4 et R1 en parallèle et avec un gain de 10, le commutateur reste en cette première position p4 de mesure.

Si la valeur de la tension Us est inférieure à 10% de cette gamme de mesures précitée, le commutateur de gain CG passe du gain 10 au gain 1, et le microprocesseur MP donne l'ordre du moteur M de déplacer l'aimant permanent AP de la position p4 vers la position p3.

Si la valeur de la tension Us est alors comprise entre 10% et 100% de la seconde gamme de mesures à laquelle correspond l'amplificateur Al contre-réactionné par les résistances R3 et R1 en parallèle et avec un gain de 1, le commutateur reste en cette nouvelle position p3 de mesure.

Si la valeur de la tension Us est inférieure à 10% de cette seconde gamme de mesures, le microprocesseur MP donne l'ordre du commutateur de gain CG de passer du gain de 1 au gain de 10.

Il se déroule ensuite le même cycle de fonctionnement que celui décrit précédemment pour passer de la position p3 à la position p2, puis p1.

Ainsi, le microprocesseur surveille en permanence la tension Us; si celle-ci vient à croître et dépasser le haut de gamme de mesures, le microprocesseur donne l'ordre de commuter sur la gamme supérieure de mesures (à la fois en commutant le gain de 1 à 10 et en commutant d'une résistance à la résistance de valeur immédiatement inférieure); si elle décroît en-dessous de 10% de la gamme de mesures, le microprocesseur donne l'ordre de commuter sur la gamme inférieure de mesure (à la fois en commutant le gain de 10 à 1 et en commutant d'une résistance à la résistance de valeur immédiatement supérieure).

Lorsque l'on cesse d'utiliser l'appareil de mesure et que l'opérateur le met donc en position «arrêt», le microprocesseur envoie au moteur M l'instruction de tourner jusqu'à la position p5. L'appareil reste alimenté par l'interrupteur IM5a qui reste fermé tant que l'aimant AP n'est pas parvenu en cette position p5. Lorsqu'il y parvient, on obtient la coupure de l'alimentation et la mise en court-circuit de l'ensemble transistor TRI-amplificateur Al par fermeture de l'interrupteur IM5. Cela met en position de sécurité le commutateur C pour protéger le transistor TR1 lors de la prochaine mise sous tension de l'appareil.

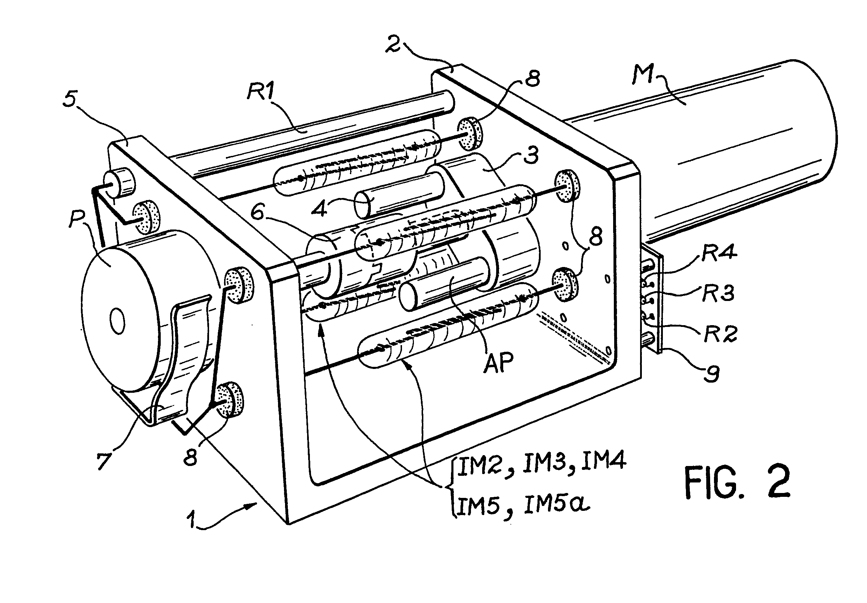

On se reportera maintenant à la figure 2 pour décrire un mode particulier de réalisation matérielle du commutateur selon l'invention.

La réalisation mécanique et le choix des composants ont été faits dans le but d'obtenir un ensemble simple et compact.

Le montage est réalisé autour d'un corps profilé 1 en U pris dans un profilé standard en aluminium.

Le moteur M est monté sur l'une des ailes 2 du profilé et son axe passe à travers un orifice de cette aile. Cet axe est solidaire d'un support tournant 3 en aluminium qui porte l'aimant AP ainsi qu'une masselotte d'équilibrage 4 diamétralement opposée.

Le potentiomètre P est monté coaxialement sur l'autre aile 5 du profilé 1. L'accouplement des axes du moteur M et du potentiomètre P est réalisé par un joint de Oldham 6. Le potentiomètre P est maintenu en position par des clips 7.

Les interrupteurs à lame souple à commande magnétique IM2, IM3, IM4, IM5 et IM5a associés tous deux, sont montés entre les ailes 2 et 5 du profilé et disposés parallèlement et équidistants de l'axe géométrique du commutateur. L'aimant permanent AP, de forme longiligne, est monté parallèlement à l'axe du commutateur de manière à pouvoir venir se positionner à proximité et parallèlement à l'un ou l'autre des interrupteurs à lame souple. Ces interrupteurs sont isolés du profilé par des traversées 8 en matériau isolant tel que du polytétrafluoroéthylène, commu sous la dénomination commerciale de «téflon».

Les résistances de hautes valeurs R2, R3 et R4 sont câblées entre les traversées isolantes 8 et une plaquette isolante 9, côté bas potentiel, et montées sur colonnettes. La résistance R1, de plus grande dimension, est montée avec isolement entre les deux ailes 2 et 5 du profilé.

L'ensemble ainsi réalisé a des dimensions hors tout de 70 × 45 × 30 mm. Il s'agit donc d'un commutateur très compact.

**Revendications**

1. Commutateur automatique à haut isolement et faibles consommation et encombrement, destiné à être associé à un appareil électrométrique constitué d'un amplificateur intégré (AI) précédé d'au moins un transistor (TR1), l'ensemble transistor-amplificateur étant contre-réactionné linéairement par des résistances de hautes valeurs (R1, R2, R3, R4) commutées selon la gamme de mesures à mettre en œuvre par des interrupteurs (IM2, IM3, IM4), ledit commutateur comprenant des moyens de commande (M, P) des interrupteurs (IM2, IM3, IM4) et des moyens de comparaison de tension /A/D, MP) caractérisé en ce que le transistor est un transistor à effet de champ (TR1) à porte isolée de très faible courant de fuite, en ce que les interrupteurs sont des interrupteurs à lame souple à commande magnétique (IM2, IM3, IM4) engendrée par un aimant permanent (AP), et en ce que les moyens de commande des interrupteurs comprennent un servo-mécanisme à moteur (M) et potentiomètre (P) pour positionner ledit aimant permanent (AP) en regard de l'un desdits interrupteurs à lame souple à commande magnétique (IM2, IM3, IM4), les moyens de comparaison de tension (A/D, MP) étant prévus pour comparer la tension de sortie (Us) dudit amplificateur (AI) et la tension (Up) délivrée par ledit potentiomètre (P) à des valeurs de consigne et caractéristique de la position dudit aimant permanent (AP) et, en outre, commander en conséquence ledit moteur (M) de déplacement de l'aimant (AP).

2. Commutateur automatique selon la revendication 1, caractérisé en ce qu'un autre interrupteur à lame souple à commande magnétique (IM5) en regard duquel vient se placer ledit aimant permanent après arrêt de l'appareil, assure la mise en court-circuit dudit ensemble transistor (TR1)-amplificateur (AI) lorsque l'appareil est hors tension.

3. Commutateur automatique selon la revendication 2, caractérisé en ce que ledit autre interrupteur à lame souple à commande magnétique (IM5) est associé à un autre interrupteur à lame souple à commande magnétique (IM5a) de coupure d'alimentation de l'appareil de mesure en position arrêt.

4. Commutateur automatique selon l'une quelconque des revendications 1 à 3, caractérisé en ce qu'il comporte: un corps profilé (1) en U ayant une base et deux ailes (2 et 5) parallèles en regard; un moteur (M) de servo-mécanisme monté à l'extérieur du corps sur l'une des ailes (2), son axe passant par un orifice de cette aile; un potentiomètre (P) de servo-mécanisme monté à l'extérieur du corps sur l'autre aile (5), son axe étant coaxial avec le premier axe et passant par un orifice de cette autre aile; un accouplement élastique (6) connectant mécaniquement les deux axes précités du moteur (M) et du potentiomètre (P); un aimant permanent (AP) de forme rectiligne parallèle aux axes précités, excentré par rapport à eux et entraîné en rotation par l'axe du moteur; plusieurs ampoules-interrupteurs (IM2, IM3, IM4, IM5 et IM5a) à lame souple à commande magnétique montées entre les deux ailes du corps profilé parallèlement à l'axe du moteur à même distance de cet axe et régulièrement espacées les unes des autres de telle sorte que ledit aimant permanent (AP) lors de sa rotation vient de placer successivement en regard et à proximité de ces ampoules-interrupteurs pour les commander; et plusieurs résistances de hautes valeurs (R1, R2, R3 et R4) montées sur l'une et/ou l'autre des ailes du corps profilé.

**Claims**

1. Automatic high insulation switcher with low power consumption and small dimensions, intended to be associated with an electrical measuring instrument formed from an integrated amplifier (AI) preceded by at least one transistor (TR1), the transistor-amplifier assembly having linear negative feedback applied by high value resistors (R1, R2, R3, R4) switched according to the measurement range to be used by switches (IM2, IM3, IM4), the said switcher including means of control (M, P) of the switches (IM2, IM3, IM4) and means of voltage comparison (A/D, MP) characterized in that the transistor is an isolated gate field effect transistor (TR1) with very low leakage current, in that the switches are magnetically controlled reed switches (IM2, IM3, IM4) driven by a permanent magnet (AP), and in that the means of controlling the switches include a servomechanism with a motor (M) and a potentiometer (P) to position the said permanent magnet (AP) opposite one of the said magnetically controlled reed switches (IM2, IM3, IM4), the means of voltage comparison (A/D, MP) being provided to compare the output voltage (Us) of the said amplifier (AI) and the voltage (Up) delivered by the said potentiometer (P) with set values characteristic of the position of the said permanent magnet (SP) and, in addition, to consequently control the said permanent magnet (AP) moving motor (M).

2. Automatic switcher according to Claim 1, chartacterized in that another magnetically controlled reed switch (IM5) opposite which the said permanent magnet is placed after stopping the device short-circuits the said transistor (TR1)-amplifier (AI) assembly when the device is in the power off condition.

3. Automatic switcher according to Claim 2, characterised in that the said other magnetically controlled reed switch (IM5) is associated with another magnetically controlled reed switch (IM5a) for switching off the power supply of the measuring instrument in the off position.

4. Automatic switcher according to any one of Claims 1 to 3, characterized in that it includes: a U-shaped body (1) having a base and two parallel sides (2 and 5) facing each other; a servomechanism motor (M) mounted on the outside of the body on one of the sides (2), its spindle passing through an orifice in this side; a servomechanism potentiometer (P) mounted outside the body on the other side (5), its spindle being coaxial with the first spindle and passing through an orifice in this other side; a flexible coupling (6) mechanically connecting the two previously mentioned spindles of the motor (M) and of the potentiometer (P); a permanent magnet (AP) of rectilinear shape parallel to the previously mentioned spindles, offset with respect to them and driven in rotation by the spindle of the motor; several magnetically controlled reed switch bulbs (IM2, IM3, IM4, IM5 and IM5a) mounted between the two sides of the shaped body parallel to the spindle of the motor at the same distance from this spindle and regularly spaced from each other such that the said permanent magnet (AP) during its rotation is successively positioned opposite and close to these switch bulbs in order to control them; and several high value resistors (R1, R2, R3 and R4) amounted on one or both of the sides of the shaped body.

**Patentansprüche**

1. Hochisolierter automatischer Schalter mit geringem Leistungs- und Raumbedarf, zur Verbindung mit einer elektromagnetischen Vorrichtung, die von einem integrierten Verstärker (AI) gebildet ist, dem wenigstens ein Transistor (TR1) vorgeschaltet ist, wobei die Transistor-Verstärkergruppe durch hochohmige Widerstände (R1, R2, R3, R4) linear gegengekoppelt ist, die entsprechend dem durch Schalter (IM2, IM3, IM4) herzustellenden Messbereich umgeschaltet werden, wobei der Schalter Steuermittel (M, P) für die Schalter (IM2, IM3, IM4) und Spannungsvergleichsmittel (A/D, MP) umfasst, dadurch gekennzeichnet, dass der Transistor ein Feldeffekttransistor (TR1) mit isoliertem Gate und geringem Leckstrom ist, dass die Schalter Schutzrohrkontakte (IM2, IM3, IM4) mit magnetischer Steuerung sind, die von einem Permanentmagnet (AP) erzeugt wird, und dass die Steuermittel der Schalter einen Servomechanismus mit Motor (M) und Potentiometer (P) umfassen, um den Permanentmagnet (AP) in Gegenüberstellung eines der Schutzrohrkontakte (IM2, IM3, IM4) mit magnetischer Steuerung zu bringen, und dass die Spannungsvergleichsmittel (A/D, MP) vorgesehen sind, um die Ausgangsspannung (Us) des Verstärkers (AI) und die von dem Potentiometer (P) gelieferte Spannung (Up) mit Einstellwerten und Kennwerten für die Stellung des Permanentmagneten (AP) zu vergleichen, und ferner als Folge den Motor (M) zur Bewegung des Magneten (AP) zu steuern.

2. Automatischer Schalter nach Anspruch 1, dadurch gekennzeichnet, dass ein zusätzlicher Schutzrohrkontakt (IM5) mit magnetischer Steuerung, demgegenüber sich der Permanentmagnet beim Abschalten der Vorrichtung anordnet, einen Kurzschluss der Transistor (TR1)-Verstärker (AI)-Gruppe sicherstellt, wenn die Vorrichtung keine Spannung aufweist.

3. Automatischer Schalter nach Anspruch 2, dadurch gekennzeichnet, dass der weitere Schutzrohrkontakt (IM5) mit magnetischer Steuerung einem anderen Schutzrohrkontakt (IM5a) mit magnetischer Steuerung zum Abschalten der Versorgungsspannung der Messvorrichtung in der AUS-Stellung zugeordnet ist.

4. Automatischer Schalter nach einem der Ansprüche 1 bis 3, dadurch gekennzeichnet, dass er umfasst: einen U-Profilkörper (1) mit einer Basis und zwei parallelen, gegenüberliegenden Schenkeln (2 und 5), einen Servo-Motor (M), der ausserhalb des Körpers an einem der Schenkel (2) angebracht ist und dessen Achse durch eine Öffnung dieses Schenkels hindurchgeht, ein Potentiometer (P) für den Servomechanismus, welches ausserhalb des Körpers an dem anderen Schenkel (5) angebracht ist und dessen Achse koaxial zu der ersten Achse verläuft und durch eine Öffnung in diesem anderen Schenkel hindurchgeht, eine elastische Kupplung (6), die mechanisch die zwei vorgenannten Achsen des Motors (M) und des Potentiometers (P) verbindet, einen Permanentmagnet (AP) von geradliniger Form und parallel zu den vorgenannten Achsen, der in Bezug auf diese exzentrisch ist und zur Drehung von der Motorachse angetrieben wird, mehrere magnetisch steuerbare Schutzrohrkontakte (IM2, IM3, IM4, IM5 und IM5a), die zwischen den zwei Schenkeln des Profilkörpers parallel zu der Motorachse und im gleichen Abstand von dieser und gleichmässig voneinander beabstandet derart angebracht sind, dass sich der Permanentmagnet (AP) bei seiner Drehung aufeinanderfolgend gegenüber und nahe dieser Schutzrohrkontakte anordnet, um sie zu steuern, und mehrere hochohmige Widerstände (R1, R2, R3 und R4), die an einem und/oder dem anderen Schenkel des Profilkörpers angebracht sind.

FIG. 1

0 099 290

FIG. 2

0 099 290